# EUROPEAN PATENT APPLICATION

(11) **EP 2 827 445 A1**
(43) Date of publication of application: **21.01.2015**
(21) Application number: 13760580.4
(22) Date of filing: 06.03.2013
(51) Int. Cl.: H01Q 9/18

(54) **RECONFIGURABLE RESONANT AERIAL WITH AN IMPEDANCE CORRECTOR**

(30) Priority: 16.03.2012 RU 2012110362
(71) Applicant: Fedosova, Nataliya, Omsk 644041 (RU)
(72) Inventor: FEDOSOV, Dmitry Vitalievich, Omsk 644041 (RU); KHORVAT, Vladislav Nikolaevich, Omsk 644060 (RU); KORNEEV, Dmitry Alekseevich, Omsk 644046 (RU)
(74) Representative: Müller & Schubert
(86) International application number: PCT/RU2013/000174
(87) International publication number: WO 2013/137779

(57) **Abstract**

The invention relates to aerial technology and can be used as a compact reconfigurable aerial for long-wave, medium-wave and short-wave communications. An aerial with an impedance corrector, consisting of an inductance coils, comprises a flat or three-dimensional vibrator. The vibrator is arranged in the magnetic field of the impedance corrector, which is in the form of a transformer. The transformer is arranged on an open core of a magnetic conductor. The vibrator is electrically connected to a secondary winding of the transformer. The transformer has a variable coefficient of transformation. The magnetic conductor is manufactured from a mixture of particles of ferromagnetic material and a non-magnetic binder. The technical result is an increase in the maximum power of the resonant aerial and the possibility of reconfiguring the working frequency thereof within a wide range of radio waves and, as a consequence, extending the functional possibilities of using a transceiver.

## Description

### TECHNICAL FIELD

This invention relates to antenna equipment and can be used in a small-sized transceiving radio communication and navigation units, as well as a separate aerial to be mounted on both stationary and mobile communication facilities.

### BACKGROUND

At present it is common knowledge that the size of effective modern antennas of hectometer and decameter bands of radio waves make dozens and hundreds meters that significantly minimize their usage in mobile radio communication and increase the time of deployment of stationary antennas to implement radio communication. These types of antennas retard the development and implementation of both hectometer and decameter radio communication and design of transceivers in the field of long- medium- and short-wave radio communication. This radio wave band suggests itself to be more attractive to implement long-range radio communication because of peculiar properties of the long, medium and short waves propagation in space.

The design of the small-sized ferrite aerial with a ferromagnetic core and receiving coils placed on it is known from the Patent of the Russian Federation No.2344433.

The drawback of this aerial is that it can be used only as a receiving one, since in the mode of a radio signal delivery to the ferrite aerial ferromagnetic material being saturated results in distortions of transmitted signal.

From the Patent of the Russian Federation No. 2324267 there is well known a broadband image oscillating antenna, containing a vertical oscillator connected to the inner conductor of a coaxial cable, a matching device comprising both the first and the second inductance, antenna inductance coil, the first and the second resistors, as well as an oscillator with a circular polar pattern in horizontal plane.

The above mentioned image oscillating antenna has the following drawback: the height of the vertical rectangular radiating element makes 0.038 λ where λ is the highest wavelength of operating band that makes 7,6 m at frequency of 1.5 MHz. Taking into account the flat rectangular design of the antenna one can arrive at a conclusion that the application of the above design in LW and MW bands in a mobile version is hardly technically feasible and in most cases is quite impossible.

The aerial, according to Patent US 3267476 is known, that contains oscillator in the form of 1 D half-wave rod, matching transformer with open magnetic core the secondary winding of which is connected to the rod, whereas the power is fed to the primary winding. However this aerial does not have the super small-sized dimensions. The similar aerial can be used as a mobile one only in the range of ultra-short waves. Application of such aerial as a mobile one in the range of short, medium and long waves is impossible due to its huge size.

The technically closest analogue to the claimed device is the aerial according to Patent RU 2413344.

This aerial contains oscillator in the form of 2D or 3D conductive body, matching transformer with open magnetic core the secondary winding of which is connected to the oscillator, whereas the power is fed to the primary winding. This aerial has small-sized dimensions and can be used for mobile radio communication; however it has some drawbacks, namely:
- It has very narrow bandwidth and can not be adjusted within required frequency band;
- While being manufactured it is tuned to required frequency with difficulty, it means that it hinders its mass production;
- Similar design of the antenna can be used effectively only for the emission of signals of portable radio stations of the small power of 1 to 5 W since when a signal of bigger power is emitted the ferrite rods out of which the magnetic core is made come into magnetic saturation and they are heat up. All that doesn't allow using these antennas to transmit the powers to some tens and hundreds of Watts and it is especially required for vehicle-borne means of communication.

### DISCLOSURE OF INVENTION

The object of the invention is to overcome the above-named drawbacks and to provide an antenna that provides a possibility to retune the operation frequency of the aerial within rather wide range, increase of transmission power preserving its small dimensions in order to expand the functional capabilities of the radio equipment for mobile systems of LW, MW and SW radio communication.

The problem is solved in that the aerial comprising matching device in the form of a transformer consisting of the primary and secondary windings, open magnetic core and oscillator in the form of flat or volumetric conductive body located in the magnetic field of transformer and connected to the secondary winding the matching transformer according to the claimed invention is made with changeable transformation ratio so that the secondary winding of the transformer has certain degree of freedom in relation to magnetic core or primary winding and it also has the device of manual or automated movement of the magnetic core and/or coils.

The claimed aerial consists of the oscillator - radiating element representing 2D flat or 3D volumetric conductive body having electric capacity. The aerial includes a matching transformer with an adjustable transformation ratio in the form of primary and secondary windings with open circuit. The transformer is located so in order that the magnetic field of the transformer could go outside the boundaries of the transformer and cover the adjacent elements of the aerial structure namely volumetric or flat oscillator. The magnetic field of the transformer is the one that with respect to its value is decreasing quickly enough. It is actually located in the space not exceeding several units of the linear dimensions of the transformer, as a rule the size of the space is less than 1% of the wavelength of the radiating aerial.

Besides, according to the claimed invention the magnetic core of the matching device of the aerial is made of a mixture of ferromagnetic material particles and nonmagnetic binding material.

### BRIEF DESCRIPTION OF THE DRAWINGS

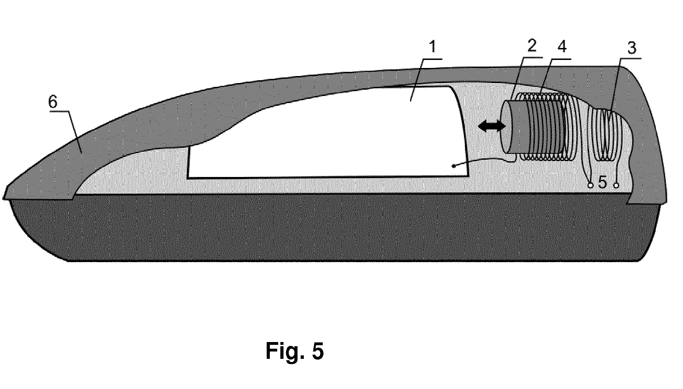

The invention is illustrated in the accompanying drawings, where Fig.1 depicts the equivalent circuit scheme of the aerial, while Fig.2 shows the structural scheme of the presented resonance aerial; Fig. 3 shows the cross-section of the aerial; Fig. 4 shows exterior appearance of the aerial; and Fig.5 illustrates the design variant of the aerial mounted on roof of the vehicle; Figure 6 shows the illustration of an embodiment of an antenna with a motorized adjustment section.

### EMBODIMENTS

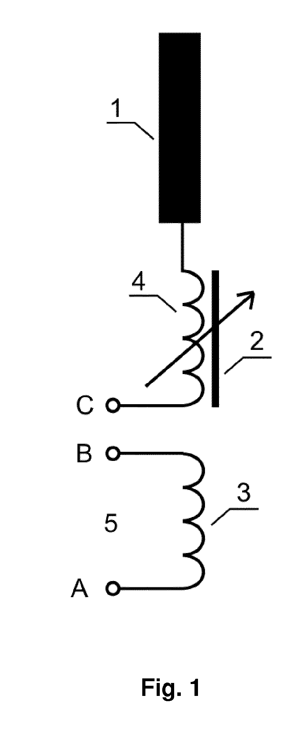

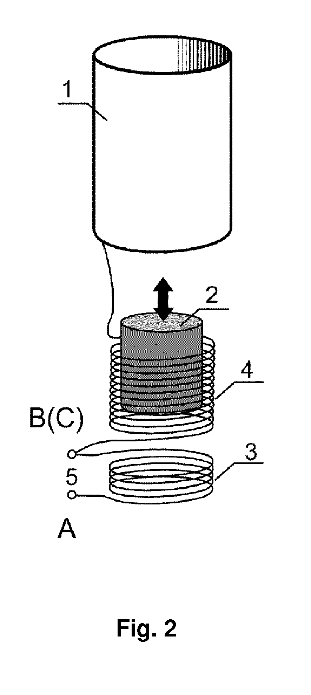

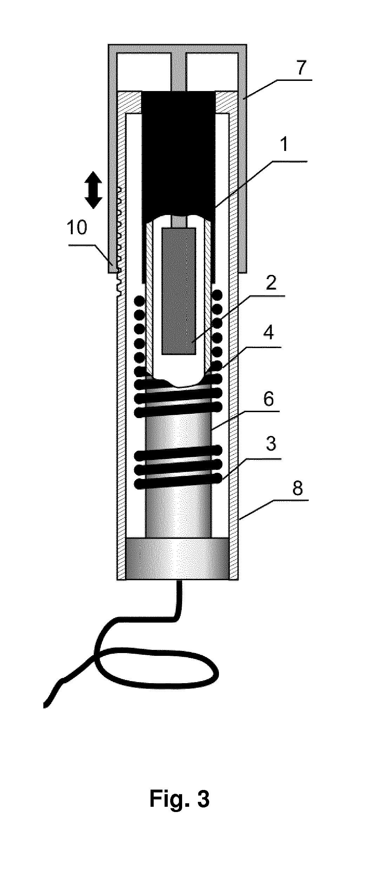

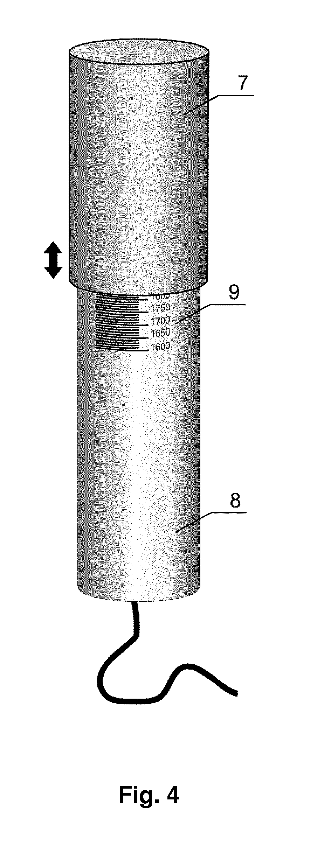

The areal in Fig. 3 and Fig. 4 consists of oscillators and transformers. The oscillator 1 of any form 2D or 3D in Fig. 2 for instance is a cylinder that can be made of any electrically conductive material. In case of a vehicle-borne variant of the aerial flat conductive elements made of a foil located on the walls of a box can serve as an oscillator, Fig. 4. The transformer is implemented on the open magnetic circuit 2 and contains the inductance coils in the form of primary 3 and secondary 4 windings of this transformer on the casing 6. The oscillator 1 made of foil located on the casing 6 is electrically connected to a secondary winding 4 of transformer and located in a magnetic field of the transformer. A feed of the aerial is carried out through the terminals A and B of a primary winding 3 of the transformer by means of a cable or directly from an antenna socket of the radio transmitting device via any connecting unit 5. The second terminal of the secondary winding of the transformer C in Fig. 1 is connected to the common wire or to the terminal of the primary windings.

The changeable transformation ratio of the matching transformer is provided by the movable magnetic core. The mechanism of manual movement and fixation of the magnetic core in relation to the secondary winding is made in the form of the tuning knob 7 that can move up and down along the aerial casing 8 and to which the magnetic core is fixed. The frequency band scale 9 can be drawn on the casing of the aerial and location of the tuning knob indicates current frequency of the resonance aerial tuning. Tuning knob is tightly bearing against the surface of the aerial casing and fixed at chosen position with the help of frictional forces and click 10.

The aerial comprising a matching device works as follows.

When a signal from the connecting unit 5 is fed to the primary winding 3 of the transformer there appears a magnetic field which induces the magnetic field inside the secondary coil 4 and open magnetic core 2. Magnetic field appears around the transformer the magnetic induction vector of which is directed along the magnetic core. The electric field intensity vector which is directed perpendicularly to the plane of the oscillator 1 emerges due a high voltage feed from the secondary step-up winding 4 of the transformer electrically connected to the oscillator 1. On the assumption that the oscillator (radiation element) 1 is inside the operating zone of the magnetic field of the transformer in such a way that the angle between the magnetic induction vector and intensity vector of the electric field induced on the "radiating element" is close to 90° then sufficient conditions for radio waves generation arise in the vicinity of the oscillator. The magnetic core is made movable along the axis of the secondary coil. Since given aerial is a resonance one and represents open tuned circuit then the change of the position of the magnetic core along the axis of the secondary winding alters the inductance of this circuit to other frequency. All that allows retuning of the aerial frequency within the band of 10 to 20% when SWR (standing-wave ratio) is not more than 1.2.

The structure of the mechanism of the movement and fixation of the magnetic core (circuit) or the coils can be accomplished in various ways including automated version, for instance by means of linear displacement servo-motor located inside the aerial on the axis of the magnetic core (circuit).

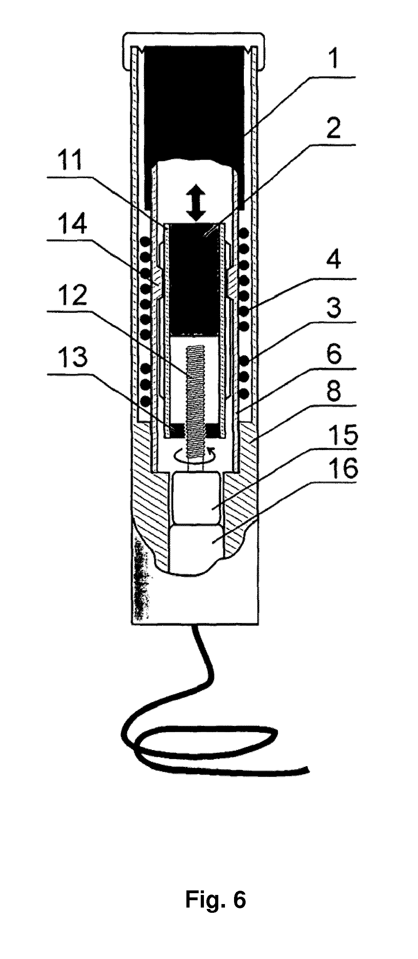

FIG. 6 shows a sectional structure of the antenna with an electromechanical mechanism for adjusting the position of the magnetic circuit with a conventional motor. Structural elements of the antenna are mounted on the three frames. In the inner frame 11, executed in the form of a tube, a ferromagnetic magnetic circuit 2 is placed. On the middle frame 8 transformer windings 3, 4 are mounted and emit a vibrator 1. Move of the core with respect to the inner frame of the transformer is carried out by an electric motor 16 and the gear 15 through the motor rotates screw 12. Screwing or unscrewing of the bolt 13, leads to the vertical movement of the structure 11 with circuit 2. Guides 14 provide a guiding of the frame 11 with respect to the axis of rotation of the rotor 12. To change the operating frequency of the antenna, the motor power supply is fed, the polarity of which depends on the direction of its rotation. At this moment, the upward or downward rearrangement of the resonant frequency of the antenna takes place.

Various magnetic cores (circuits) for matching devices are known. All of them are made of ferromagnetic materials - ferrites, transformer steel, amorphous iron foil. The use of ferrite magnetic cores (circuits) possessing good frequency characteristics in the matching devices of the small-sized aerials during the transmitting of signal of big power in the condition of a resonance results in magnetic saturation of ferromagnetic material, warming up and losses.

In order to increase the power of transmitting signal, while preserving the overall dimensions of the aerial, a composite magnetic core is used, which is not an integral magnetic material but it is made of a mixture of magnetic material particles and nonmagnetic binding substance, for example, polymer adhesive and ferrite powder and it results in the saturation of magnetic material achieved at bigger power transmitted into the aerial.

### INDUSTRIAL APPLICABILITY

The invention can be industrially realized by means of facilities, technologies and materials already.

This invention essentially expands the operation frequency range, considerably increases the power of radiation for small-sized resonance aerials and simplifies the tuning of the aerials during their industrial-scale manufacturing.

## Claims

1. An aerial with matching device comprising matching device in the form of a transformer consisting of the primary and secondary windings, open magnetic core and radiating oscillator in the form of flat or volumetric conductive body connected to the secondary winding and located in the magnetic field of the matching transformer differs in the fact that the matching transformer is made with changeable transformation ratio so that the secondary winding of the transformer has certain degree of freedom in relation to magnetic core or primary winding and it also has the device of manual or automated movement of the magnetic core and/or coils relative to each other and fixation at chosen position.

2. The aerial according to claim 1, **characterized in that** the magnetic core is made of a mixture of particles of ferromagnetic material and nonmagnetic binder.

3. The aerial with matching device comprising matching device in the form of a transformer consisting of the primary and secondary windings and open magnetic core, radiating oscillator in the form of flat or volumetric conductive body connected to the secondary winding and located in the magnetic field of the matching transformer, **characterized in that** the magnetic core is made of a mixture of ferromagnetic material particles and nonmagnetic binding substance.
